# EUROPEAN PATENT SPECIFICATION

(11) **EP 0 395 415 B1**
(45) Date of publication and mention of the grant of the patent: **15.03.1995**
(21) Application number: 90304544.1
(22) Date of filing: 26.04.1990
(51) Int. Cl.: H01J 37/32, H05H 1/46

(54) **Apparatus for and method of processing a semiconductor device using microwave-generated plasma**
Gerät und Verfahren zur Bearbeitung einer Halbleitervorrichtung unter Verwendung eines durch Mikrowellen erzeugten Plasmas
Appareil et procédé de traitement d'un dispositif semi-conducteur utilisant un plasma produit par micro-onde

(30) Priority: 03.07.1989 JP 171662/89; 27.04.1989 JP 108553/89; 01.03.1990 JP 49810/90
(43) Date of publication of application: 31.10.1990
(73) Proprietor: FUJITSU LIMITED, Kawasaki-shi, Kanagawa 211 (JP); FUJI ELECTRIC CO. LTD., Kawasaki 210 (JP)
(72) Inventor: Doki, Masahiko, 4-3-3, Aioi, Sagamihara (JP); Ooiwa, Kiyoshi, Nagasaka, Yokosuka (JP)
(74) Representative: Carmichael, David Andrew Halliday

(56) References cited:
- EP-A- 0 145 015
- GB-A- 2 212 974
- US-A- 4 795 529

## Description

The present invention generally relates to apparatus for and a method of processing a semiconductor device using microwave-generated plasma to effect surface treatment such as dry etching or the formation of a thin film by means of CVD (Chemical Vapour Deposition). More particularly, the apparatus and method involve applying an RF (Radio Frequency) bias voltage to a substrate to be processed.

In such plasma processing, it is required arbitrarily to control, during etching, the anisotropy of etching, damage to the substrate surface, and the processing speed of etching, and during thin-film formation, the composition of the film such as the state of coupling between atoms, film quality such as water permeability, stress imparted to the film, and step coverage, respectively. However, it is not easy to realise apparatus that can simultaneously satisfy these various conditions. In recent years, a microwave plasma processing apparatus which employs ECR (Electron Cyclotron Resonance) plasma has attracted much attention as an apparatus having the possibility of satisfying these conditions. The ECR plasma is based on the principle that electrons can be accelerated by making use of resonance effects created between a magnetic field and microwaves, and a gas is ionized by using the kinetic energy of the electrons, thereby generating the plasma. The electrons excited by the microwaves make circular motions around the lines of magnetic force. In this case, a condition under which the centrifugal force equilibrates the Lorentz force is referred to as an ECR condition. Let the centrifugal force be mrω² and the Lorentz force be -qrωB, then the condition of their equilibrium is expressed as ω/B = q/m, where ω is the angular frequency of the microwaves, B is the density of magnetic flux and q/m is the specific charge. A commonly used microwave frequency is 2.45 GHz which is industrially adopted as standard. In this case, the resonance magnetic flux density is 875 gauss.

The ECR plasma etching/CVD apparatus requires a step of transforming the microwaves into pulses having a large peak power preparatory to the microwaves being introduced into the plasma generating chamber to generate the plasma, for the purpose of effecting highly efficient etching or forming the thin film, by providing a high density of plasma. It is common practice that an RF (Radio Frequency) bias voltage is applied between the plasma and the substrate to be processed in order to perform the processing with high anisotropy in the etching process. Radio Frequencies range from approximately 50 kHz to several tens MHz. As in the case of the etching process during thin film formation, grooves and holes formed in the substrate surface can be covered uniformly with a high density film by applying the RF bias voltage when forming the thin film. In addition, if the substrate surface is formed with stepped portions, these stepped portions can be eliminated to form a level surface. The reason for this is that when plasma is generated, a so-called floating potential is produced on the substrate surface (or the surface of the thin film formed on the substrate surface) owing to a difference in the mobility of electrons and ions that are present in the plasma, but if an RF bias voltage is applied, the magnitude of this floating potential can be controlled, so that it is possible to control the energy of ions directed toward the substrate surface or the thin-film surface. It may also be that when an RF bias voltage is applied, the electric fields are produced not only in the direction perpendicular to the substrate surface but also parallel to the substrate surface. This effectively acts on the formation of thin film and the concentration of electric fields facilitates the cleaning of excess deposits from pointed portions on the substrate surface.

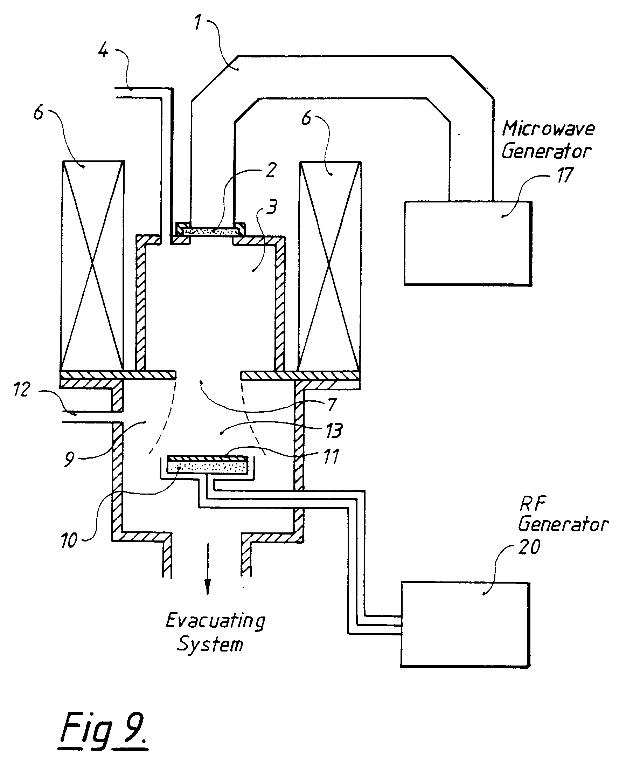

A known form of ECR plasma etching/CVD apparatus is shown in Fig. 9. The configuration and operation of this apparatus will be described below. First, a plasma generating chamber 3 and a processing chamber 9 are evacuated by evacuating means (not shown). Nitrogen (N₂) gas is made to flow from gas supplying means 4 into the plasma generating chamber 3, at which time pulse-like microwaves generated by a microwave generator 17 are introduced via a waveguide 1, serving as transferring means, into the plasma generating chamber 3.

Provided between the plasma generating chamber 3 and the waveguide 1 is a vacuum window 2 for isolating in an airtight manner the evacuated plasma generating chamber 3 from the waveguide 1 under atmospheric pressure. The lower portion of the plasma generating chamber 3 is fitted with a metallic plate formed with a central opening 7 having a large diameter. The metallic plate and the plasma generating chamber 3 are combined to constitute a half-open microwave resonator. Disposed outside the resonator is an excitation solenoid 6 by which magnetic fields satisfying ECR conditions are produced in the resonator. As a result, the plasma is generated in the resonator. The plasma is forced out into the processing chamber 9 along a transfer path 13 formed by magnetic force. Subsequently a gas such as monosilane gas (SiH₄) is fed from gas supplying means 12 into a space extending to a substrate support board 10. This gas is activated by the plasma to produce an active species which immediately reacts on a substrate 11 to be processed and to which an RF bias voltage is applied from the RF generator 20, whereby a thin film is formed on the substrate surface. Note that a wire for applying the RF bias voltage to the substrate 11 is covered by means of a shield at earth potential, and the peripheral surface of the substrate 11 is surrounded by the shield at earth potential.

The ECR plasma etching/CVD apparatus is also usable for etching the substrate by feeding a gas for etching from the gas supplying means 4 instead of N₂ gas.

However, the following problems are inherent with this type of conventional ECR plasma etching/CVD apparatus.
1. Since plasma is generated when the microwaves are introduced into the plasma generating chamber and no microwave is generated during a portion of the pulse cycle of the microwaves, plasma is also not produced at this time. When applying the RF bias voltage, the plasma becomes a load during its production and an impedance matching is thereby possible. It is therefore possible during this time to apply an adequate voltage to the substrate. Where no microwave and no plasma is generated, however, as seen from the RF generator 20, there is created a no-load state, and the impedance cannot be matched. Meanwhile, if the RF bias voltage is previously adjusted to provide matching during production of plasma, the impedance is inevitably mismatched when no plasma is generated, thereby applying an undesirably high voltage to the substrate. This high voltage is in some cases approximately 1 kV, and electric discharge takes place on the substrate surface. As a result, there arises a problem in that craters are formed in the substrate surface and breakage results.
2. In addition, while plasma is being generated, a floating potential is produced on the substrate surface, as described above. This floating potential is controlled by means of the RF bias voltage and is also dependent on the impedance of the plasma (determined substantially by the electrical power of the microwaves supplied) when the RF bias voltage is being applied. Accordingly, when carrying out surface treatment of the substrate by means of ions in the plasma under the action of the electrical power of certain microwaves, if an attempt is made to obtain an optimum value of floating potential (i.e. a mean value in time: since it is difficult for ions in the plasma to follow the RF, the mean value in time of the floating potential becomes an issue when the RF bias voltage is being applied), the value (peak value) of the RF bias voltage is unconditionally set at a certain value. Meanwhile, in various types of processing, there are cases where the optimum value (mean value) of the floating potential determined by this RF bias voltage does not correspond with the optimum value (peak value) of the RF bias voltage itself. That is, if the peak value of the RF bias potential is set to be a value which produces an optimum mean value of the floating potential, there are cases where the peak value itself of the RF bias voltage becomes an inadequate value. As a result, it becomes difficult for conditions of processing at the time of effecting the etching or CVD process to satisfy simultaneously desired processing characteristics of various types, so that there has been a problem in that the results of processing are difficult to control. For instance, in the formation of a thin film, there are cases where even if the peak value of the RF bias voltage is an optimum value with respect to the film quality, stress applied to the film becomes excessively large. Similarly in the etching process there are cases where even if the peak value of the RF bias voltage is an optimum one for improving anisotropy, damage to the substrate surface becomes considerable due to the sputtering of ions from the plasma.

Accordingly, to try to provide ECR plasma etching/CVD apparatus for overcoming 1. mentioned above, it has been proposed to use apparatus as shown in Fig. 10, (see GB-A- 2212974 which corresponds with JP-A- 1236629 or Japanese Patent Application No. 275786/1988). The arrangement and operation of this apparatus will be described below.

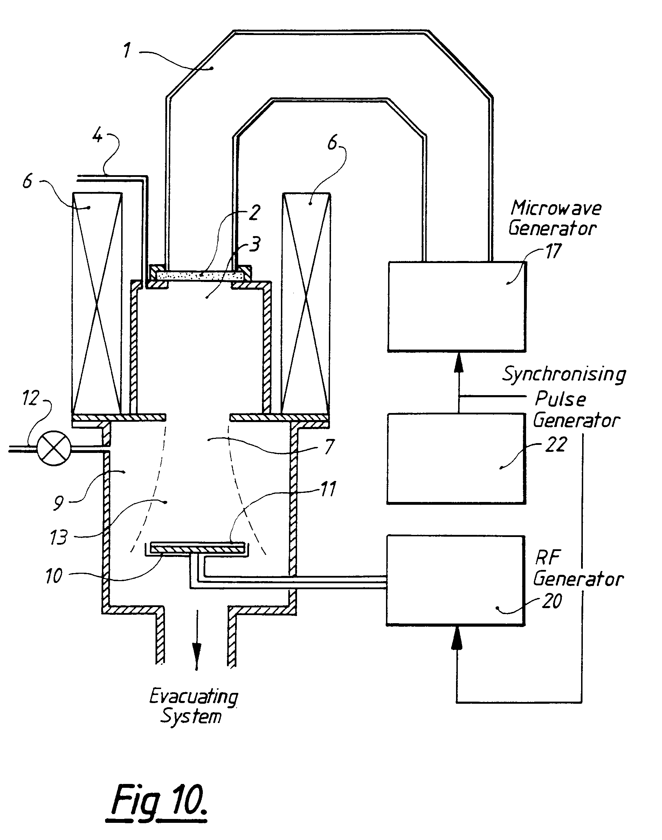

Those components shown in Fig. 10 that are identical with those shown in Fig. 9 are denoted by the same reference numerals and will not necessarily be referred to again below.

In the apparatus shown in Fig. 10, the application of RF bias voltage to a substrate 11 is effected by a synchronisation pulse generating circuit 22 in synchronism with the pulses of microwaves. During time intervals when the microwaves are not being produced during pulse cycles of the microwaves, the RF bias voltage is not applied to the substrate.

Hence, with this apparatus, it is possible to overcome 1. above of the apparatus shown in Fig. 9, i.e. the problem that if a high voltage is continuously applied to the substrate, discharge takes place on the substrate surface, and craters are produced in the substrate surface, resulting in breakage.

However, problem 2. of the apparatus shown in Fig. 9 cannot be solved by the ECR plasma etching/CVD apparatus shown in Fig. 10. A more detailed explanation will be given of this problem.

As described above, it is only when the microwaves have been introduced into the plasma generating chamber that the plasma is generated. Hence, the RF bias voltage is applied only when the plasma is being generated in the pulse cycles of the microwaves, whereby impedance matching is provided with the plasma acting as load, and an adequate voltage is applied to the substrate.

With the apparatus shown in Fig. 10, however, the pulse width (i.e. duration) for the application of the RF bias voltage is identical with the pulse width (i.e. duration) of the microwave pulses, and its magnitude is fixed. If, for instance, an attempt is then made to increase the RF bias voltage to be applied to the substrate so as to obtain desired film quality, this results in a high voltage being output from the RF generator for a time identical with the pulse duration of the microwave pulses.

However, as described above, there are cases where the optimum mean value of the floating potential determined by the RF bias voltage does not correspond with the optimum peak value of the RF bias voltage itself. For that reason, in the arrangement as shown in Fig. 10, in which the RF bias voltage of a fixed magnitude is generated for the same pulse duration as that of the microwave pulses, although it may be an optimum for producing a predetermined floating potential, the RF bias voltage itself has a peak value of a magnitude greater than the optimum value and must be applied for a significantly longer time than is necessary. As a result, it is impossible to satisfy simultaneously the desired processing characteristics of various types. A specific example will be described below.

When forming a thin film on the substrate, for instance, in order to improve the step coverage of the stepped portions of the substrate surface, it is necessary to increase the RF bias voltage to be applied, set the magnitude of floating potential produced on the substrate above a certain threshold value, and deposit a thin film on side walls of the stepped portions by means of a sputtering effect using ions. However, as mentioned above, the value of the floating potential determined by the RF bias voltage and used for ion acceleration in the sputtering process is a mean value in time.

By contrast, the instantaneous potential which actually appears on the substrate has a relatively large peak amplitude. Consequently, if an attempt is made to set the peak value of the RF bias voltage applied with a fixed magnitude for the same pulse duration as that of microwave pulses in such a manner as to be large enough to create a sufficient mean value of the floating potential for producing the sputtering effect, inside the so-called sheath which is present between the plasma and the substrate surface, the electrons and ions are repeatedly accelerated and decelerated and there is variation in the film quality and in the magnitude of stress applied to the film. As a result, if the RF bias voltage with a large amplitude is applied for a sufficiently long time, the film quality and the stress applied to the film vary undesirably far from ideal values. In particular, when forming a thin film of silicon nitride, the stress in the film is liable to be excessively large.

It is a first object of the present invention to provide a plasma processing apparatus and method in which the mean value of floating potential on a substrate surface to be processed can be controlled to a desired value over a wide range of values and the film composition, film quality, and stress applied to the film can be selectively controlled in the formation of thin film, while anisotropy, damage to the film, and processing speed can be selectively controlled in etching.

It is a second object of the present invention to provide a plasma processing apparatus and method which is capable of enabling adequate control of the various characteristics in thin-film formation and etching and more particularly to provide a plasma processing apparatus and method enabling adequate film composition, film quality, and tolerable stress applied to the film during thin-film formation and for enabling favourable step coverage.

According to a first aspect of this invention there is provided apparatus for processing a semiconductor device using microwave-generated plasma, said apparatus comprising a plasma-generating chamber arranged to receive a gas and pulsed microwaves and having means for providing a magnetic field in the chamber so as to generate a plasma due to resonance effects between the gas and the microwaves, said magnetic field serving to guide the plasma from the plasma-generating chamber into a processing chamber having means for supporting a substrate with one of its surfaces arranged for thin-film formation or etching using said plasma, means being provided for evacuating the chambers, an RF bias generator, an RF bias modulation circuit, a DC bias generator and a DC bias modulation circuit being provided for respectively supplying and independently adjusting an RF bias voltage and a DC bias voltage, means for mixing the two bias voltages and for supplying an interference-free combination of the latter to said substrate. and synchronising means being provided for synchronising the bias voltages with the microwave pulses.

According to a second aspect of this invention there is provided a method of processing a semiconductor device using microwave-generated plasma in the apparatus described above, said method comprising the steps of supplying to a previously evacuated plasma-generating chamber a gas and pulsed microwaves and providing a magnetic field in the chamber so as to generate a plasma due to resonance effects between the gas and the microwaves, said magnetic field serving to guide the plasma from the plasma-generating chamber into a previously evacuated processing chamber, supporting a substrate in the processing chamber with one of its surfaces arranged for thin-film formation or etching using said plasma, supplying and independently adjusting an RF bias voltage and a DC bias voltage, mixing the two bias voltages and supplying an interference-free combination of the latter to said substrate. and synchronising the bias voltages with the microwave pulses.

According to a third aspect of this invention there is provided apparatus for processing a semiconductor device using microwave-generated plasma, said apparatus comprising a plasma-generating chamber arranged to receive a gas and pulsed microwaves and having means for providing a magnetic field in the chamber so as to generate a plasma due to resonance effects between the gas and the microwaves, said magnetic field serving to guide the plasma from the plasma-generating chamber into a processing chamber having means for supporting a substrate with one of its surfaces arranged for thin-film formation or etching using said plasma, means being provided for evacuating the chambers, an RF bias generator being provided for supplying and independently adjusting an RF bias voltage, such that its magnitude varies with time in a predetermined manner during each microwave pulse, synchronising means being provided for synchronising the RF bias voltage with the microwave pulses.

According to a fourth aspect of this invention there is provided a method of processing a semiconductor device using microwave-generated plasma in the apparatus described above, said method comprising the steps of supplying to a previously evacuated plasma-generating chamber a gas and pulsed microwaves and providing a magnetic field in the chamber so as to generate a plasma due to resonance effects between the gas and the microwaves, said magnetic field serving to guide the plasma from the plasma-generating chamber into a previously evacuated processing chamber, supporting a substrate in the processing chamber with one of its surfaces arranged for thin-film formation or etching using said plasma, supplying and independently adjusting an RF bias voltage, such that its magnitude varies with time in a predetermined manner during each microwave pulse, synchronising the RF bias voltage with the microwave pulses.

Embodiments of this invention will now be described, by way of example, with reference to the accompanying drawings in which:-
Fig. 1 is a schematic diagram of a first form of plasma processing apparatus embodying the present invention;
Fig. 2 is a block circuit diagram of synchronisation means for use in the apparatus shown in Fig. 1;
Fig. 3 is a block circuit diagram of an RF bias modulation circuit and a DC bias modulation circuit for use in the apparatus shown in Fig. 1;
Figs. 4(a) and 4(b) are circuit diagrams of respective different forms of an RF/DC bias mixing circuit for use in the apparatus shown in Fig. 1;
Fig. 5 is a schematic diagram of a second form of microwave plasma processing apparatus arranged for carrying out a plasma processing method of the present invention;
Fig. 6 is a block circuit diagram of an RF bias modulation circuit used in the apparatus shown in Fig. 5;
Figs. 7 and 8 are waveform diagrams illustrating changes in timing of RF power output from the RF generator in synchronism with pulsed microwaves, respectively;
Fig. 9 is a schematic diagram of conventional RF bias voltage plasma processing apparatus; and
Fig. 10 is a schematic diagram of a previously proposed microwave plasma processing apparatus.

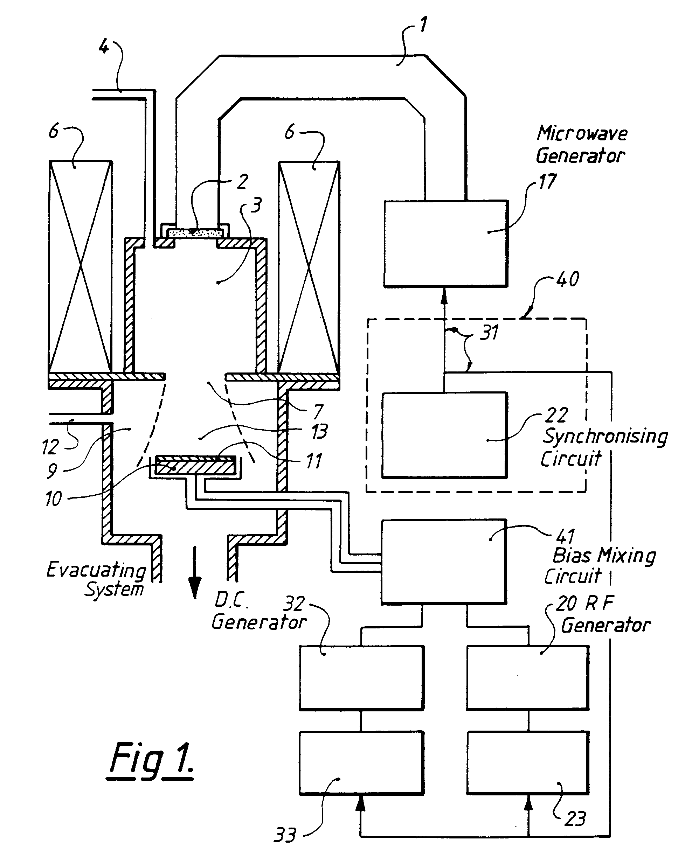

Referring now to Fig. 1, there is shown a first embodiment of ECR plasma etching/CVD apparatus. Those components shown in Fig. 1 which are identical with those in Fig. 10 are denoted by the same reference numerals, and will not be described further.

In the apparatus shown in Fig. 1, synchronising means 40 for synchronising times at which pulse-like microwaves, RF bias voltage and DC bias voltage are generated comprises a synchronisation pulse generating circuit 22 and pulse signal transmitting means 31.

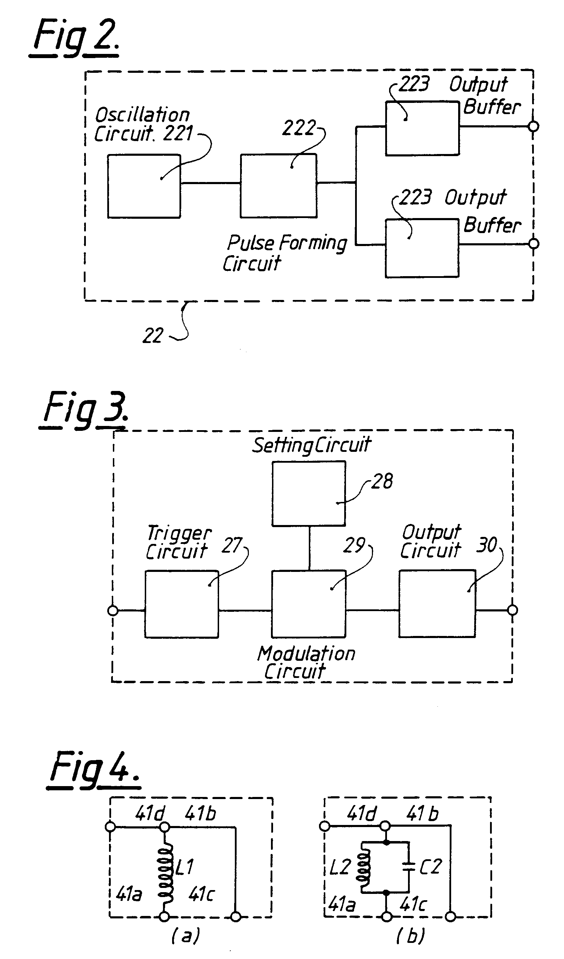

The synchronisation pulse generating circuit 22 is shown in Fig. 2 in greater detail. An oscillation circuit 221 serves to generate an alternating current at a frequency of 100 Hz or thereabouts. The alternating current is transformed into rectangular waves by means of a pulse forming circuit 222.

The rectangular waves are transmitted via pulse signal transmitting means 31 (Fig. 1) to a microwave generator 17 via an output buffer 223 (Fig. 2) having a current amplifying function and comprising operational amplifiers and an IC (integrated circuit), thereby generating microwaves.

At the same time, the rectangular waves are input to an RF bias modulation circuit 23 and a DC bias modulation circuit 33, and desired waveform, i.e. RF bias voltage and DC bias voltage each having a selected magnitude, are respectively output from RF generator 20 and DC generator 32 simultaneously with the microwaves in dependence on the outputs from the modulation circuits 22,23.

The RF bias modulation circuit 23 and the DC bias modulation circuit 33 are both provided by means of a circuit configuration as shown in Fig. 3. Specifically, by inputting the rectangular waves to a trigger circuit 27, the bias modulation circuit is started. Data which has been preset in a setting circuit 28 is input as an electrical signal via a modulation circuit 29 to the RF generator 20 or the DC generator 32 in following stages via an output circuit 30. Then, a desired waveform, i.e. a bias voltage of a desired magnitude, is generated by means of the RF generator 20 and the DC generator 32, respectively, synchronously with the microwaves and is input to an RF/DC bias mixing circuit 41.

In one form, as shown in Fig. 4(a), the RF/DC bias mixing circuit 41 is configured as an inductance L1 whose input-side terminal 41a is connected to an output terminal of the DC generator 32 and whose output-side terminal 41b is connected to an output terminal of the RF generator 20 via an input terminal 41C of the circuit 41.

In a second form, as shown in Fig. 4(b), the RF/DC mixing circuit 41 is configured as a parallel resonance circuit resonating at the frequency of the RF waves and comprising an inductance L2 and a capacitor C2 instead of just the inductance L1. The RF/DC bias mixing circuit 41 serves to supply the DC bias voltage and the RF bias voltage to the substrate without any interference.

As a result of adopting the above-described configuration, in the plasma processing apparatus in this embodiment, it becomes possible to control independently the RF bias voltage and the DC bias voltage, and it becomes possible to control the mean value of the floating potential independently of the peak value of the RF bias voltage.

By simultaneously applying the RF bias voltage and the DC bias voltage to the substrate, it becomes possible not only to provide desired processing conditions but also to widen the scope or range of processing conditions. That is, the substrate, when the bias voltage is applied thereto, exhibits a voltage such as to cause the aggregate amount of charge on the substrate to become zero.

Hence, in a case where only the RF bias voltage is first applied to the substrate, even if charges are liable to be accumulated on the substrate due to a difference in mobility between the positively charged particles and the negatively charged particles reaching the substrate, the centre (mean value) of the waveform of the oscillating potential on the substrate moves in such a manner as to make this accumulation zero. This central (mean value) potential, i.e. floating potential, varies depending on the magnitude of the RF bias voltage and also depends on the impedance of the plasma. If the DC bias voltage is further applied to the substrate whose floating potential is thus determined, the floating potential of the substrate moves further in such a manner as to make the accumulated charges zero with this DC bias voltage applied. Accordingly, by independently changing the respective magnitudes of the DC bias voltage and the RF bias voltage, it becomes possible to control the value of the floating potential over a wide range, with the result that it is possible to expand the range of processing conditions for film formation or etching.

In other words, if the floating potential is determined by the RF bias voltage, the floating potential sensed by the ions involved in the processing of the substrate is a mean value in time. In the case where the RF bias voltage having, for instance, a large amplitude (peak) is applied to the substrate surface, since, with regard to various processing characteristics, there are cases where an optimum value (peak value) of the RF bias voltage and an optimum value (mean value) of the floating potential to be determined by the application of the RF bias voltage do not correspond with each other, the film quality and other characteristics may be adversely affected by the RF bias voltage having such a large peak.

However, if a DC bias voltage is also applied simultaneously, the mean value of the floating potential can be shifted independently of the RF bias voltage thanks to the action of the DC bias voltage in itself. Accordingly, by applying an RF bias voltage with a small peak value, it is possible to produce a floating potential (mean value) equivalent to that of a case where an RF bias voltage having a large peak value is applied. Conversely, it is possible to make the value (mean value) of the floating potential small when it is desirous to apply an RF bias voltage having a large peak value. Hence, both the mean value of the floating potential and the peak value of the RF bias voltage can be made optimum values simultaneously.

Furthermore, if the synchronisation with pulsed microwaves is effected for the RF bias voltage only, and the DC bias voltage were to be continuously applied to the substrate, the potential of the substrate would move in the same way as when the RF bias voltage is applied when the plasma is not being generated, so that there are cases where the substrate surface may be damaged depending on the magnitude of the DC bias voltage. Consequently, this gives rise to the problem that the magnitude of the DC bias voltage applied to the substrate is restricted, thus imposing undesirable restrictions in the processing conditions. However, when both the RF bias voltage and the DC bias voltage are applied in synchronism with the pulsed microwaves, and no RF bias voltage nor DC bias voltage is applied to the substrate when the plasma is not present in the plasma generating chamber, damage to the substrate surface can be avoided.

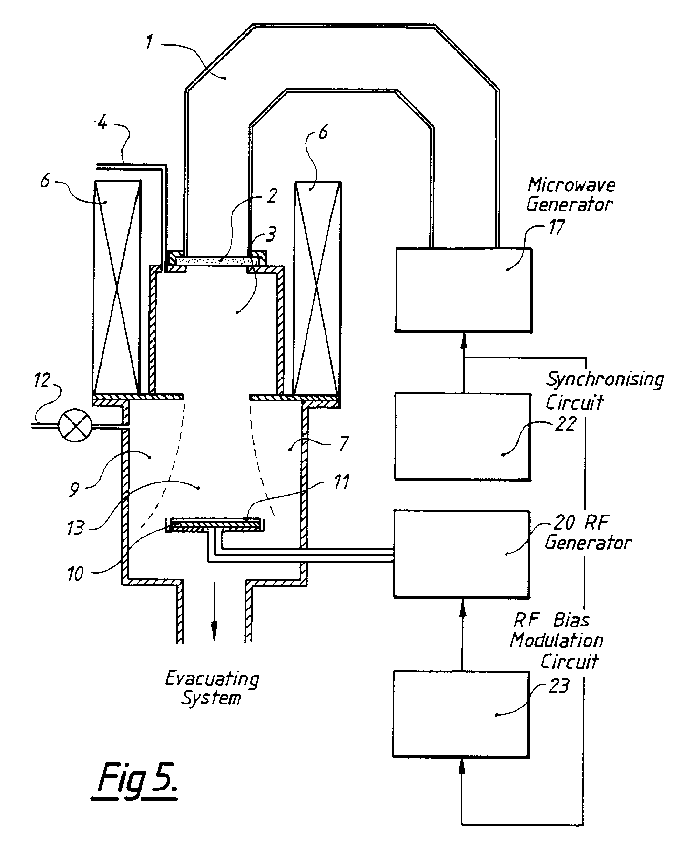

In Fig. 5 there is shown an embodiment of microwave plasma processing apparatus for carrying out a plasma processing method in accordance with the present invention. In Fig. 5, those components that are identical with those shown in Fig. 10 are denoted by the same reference numerals, and will not be described further.

A synchronisation pulse generating circuit 22 for synchronising the application of the RF bias voltage to the substrate 11 with the pulsed microwaves is the same as that shown in Fig. 2 and transmits rectangular waves to the microwave generator 17 and the RF bias modulation circuit 23 via the output buffers 223. A voltage whose magnitude varies in a predetermined manner with time is output from the RF bias modulation circuit 23 and is input to the RF generator 20 to produce a modulated RF voltage whose magnitude changes in accordance with the input voltage.

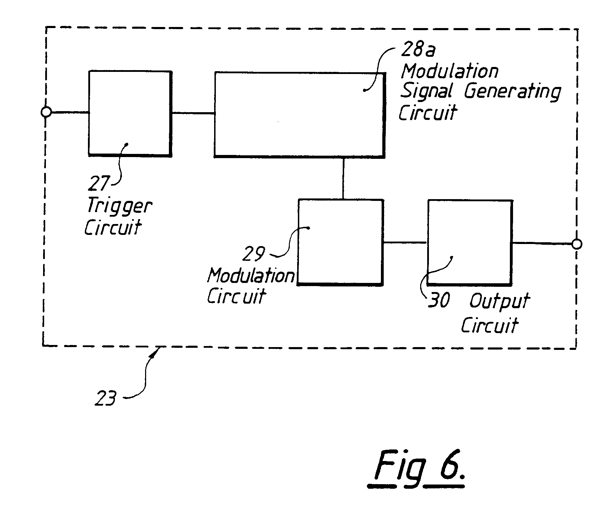

As shown in Fig. 6, the RF bias modulation circuit 23 comprises the trigger circuit 27, a modulation signal generating circuit 28a, modulating circuit 29, and output circuit 30. By inputting the rectangular waves from the synchronisation pulse generating circuit 22 to the trigger circuit 27, the modulation signal generating circuit 28a is started in synchronism with the microwave pulses, and a signal voltage whose magnitude changes in a predetermined manner with time is input to the modulation circuit 29. The waveform formed by the modulation circuit 29 is input to the RF generator 20 via the output circuit 30 which has a current amplifying function and the RF voltage whose magnitude varies in a predetermined manner with time in synchronism with the microwave pulses is output from the RF generator 20. It should be noted that the RF bias modulation circuit shown in Fig. 6 is slightly different from the one shown in Fig. 3 and is capable of making the waveform of the RF voltage a more complex one by virtue of the function of the modulation signal generating circuit 28a.

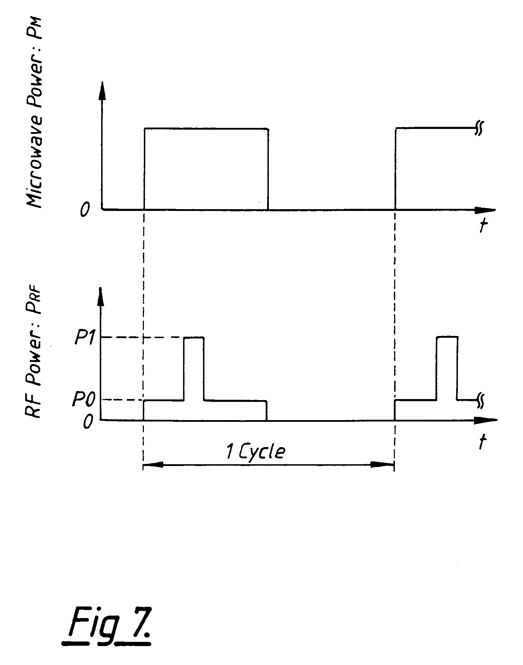

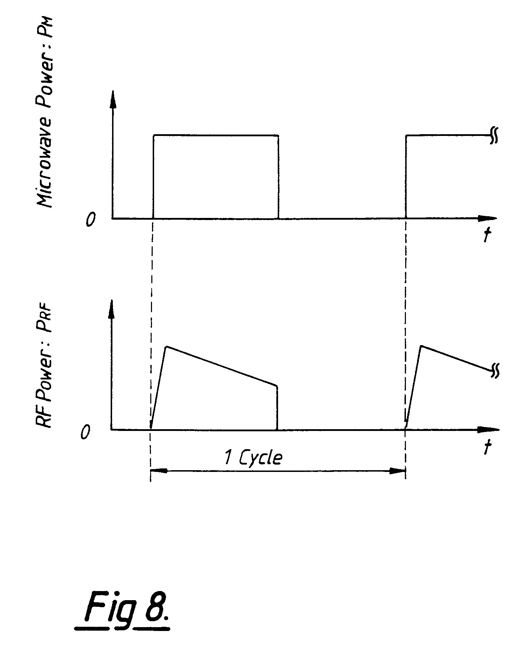

Figs. 7 and 8 illustrate examples of how the RF electrical power output from the RF generator 20 can vary in synchronism with the microwave pulses.

Fig. 7 illustrates a case in which a thin film is formed on the substrate surface with output from the RF generator 20 of electrical power. A base level P₀ of the RF electrical power necessary for a predetermined film-forming rate changes to peak power level P₁ for a short time during the time interval when microwaves are generated in each pulse cycle of the pulsed microwaves.

When peak power level P₁ with a high crest value (a value enabling the sputtering effect) is output, a high RF bias voltage is applied to the substrate 11, with the result that the floating potential on the substrate becomes large during the time when the peak power level P₁ is provided.

Consequently, thin-film substance which has been deposited on stepped portions of the substrate surface in such a manner as to project laterally from the surfaces of projecting portions is subject to sputtering using ions contained in the plasma or using an active species accelerated by means of the ions. The formation of the thin film on the recessed portions and side wall portions is thus carried out without being hampered by the laterally projecting deposits on the projecting portions.

Thus, it is possible to form a thin film having a uniform film thickness and excellent step coverage over the whole of the stepped portions and side wall surfaces without increasing the mean power output from the RF generator 20. That is, as a result of adopting the apparatus and method of the present invention, it is readily possible to form a silicon nitride film (providing an insulating film or a passivation film or the like) for which the problem of stress applied to the film has been particularly noticeable when the RF bias voltage necessary for producing the sputtering effect is continuously applied to the substrate.

In addition, since the application of the RF bias voltage to the substrate 11 is effected within the time interval when the microwaves are being generated, a high voltage due to impedance, mismatching is prevented from appearing on the substrate surface, so that discharge on the substrate surface does not occur, and does not give rise to damage to the substrate surface.

Fig. 8 illustrates a case where the RF power which is produced during the microwave-generation time interval of each cycle of the microwave pulses, rises in an inclined manner, and is gradually attenuated with time. By adopting such a waveform, it is possible to prevent the non-uniformity of the RF bias voltage due to the droop caused by a DC cutting capacitor, (not specifically shown in Fig. 5), which is interposed between the substrate base 10 and the RF generator 20. It is thus possible to form a film under conditions that are substantially free from undesirable variation.

It is thus possible to enhance the range of processing conditions while preventing electrical discharge on the substrate by adopting a surface treatment method wherein the RF bias voltage to be applied to the substrate is generated in synchronism with the pulsed microwaves, and surface treatment is effected while the magnitude of the RF bias voltage is varied with time in a predetermined manner within the pulse duration of the microwaves.

During substrate processing (e.g. film formation) even if it is desirable to supply an RF bias voltage with a large peak value in order to obtain a sufficient floating potential (mean value), it may be impossible to obtain sufficient floating potential under the condition in which the RF bias voltage can actually be applied, so that there occur cases where the desired film quality cannot be obtained. In such cases, if an RF bias voltage is applied having a shorter time duration at the peak value than the pulse duration of the microwaves, it is possible to apply an RF bias voltage with a large peak value without increasing the average electrical power applied.

For instance,a thin-film substance may be deposited on groove entrance surfaces in such a manner as to block the groove entrances and prevent the formation of a dense film on the side surfaces of the grooves which may be of submicron width. However, using the short-time high peak value RF bias voltage, such deposits can be sputtered into the grooves, thereby making it possible to improve the film quality without increasing the average electrical power supplied from the RF generator.

In other words, in order to enable the thin film to be deposited with good step coverage on the side surfaces of the grooves, i.e. stepped portions, it is necessary to supply an RF bias voltage with a large peak value to increase the mean value in time of the floating potential so as to enhance the ion sputtering effect. However, the sputtering effect is not produced unless ions are accelerated by the acceleration voltage (in this case the floating potential corresponds to the acceleration voltage) above a certain threshold value. This threshold value is several tens of volts although it varies depending on the material to be sputtered. If an RF bias voltage having a magnitude for which this sputtering effect is sufficient is continuously applied to the substrate, there are cases where stress applied to the film becomes significant. However, a sufficient sputtering effect can be realised without undesirably high stress if the average electrical power for RF bias is kept at a low level, and the peak value of the RF bias voltage is increased only for a relatively short time during each microwave pulse so that the mean value in time of the floating potential becomes large during that short time only.

Thus, it is possible to control film quality without causing damage to the substrate surface or increasing the mean value of the RF electrical power, so that processing conditions can be optimised.

The ECR plasma etching/CVD apparatus is so arranged as to comprise DC generating means for applying DC bias voltage in addition to the RF bias voltage. The apparatus has synchronising means for synchronising the timing at which the pulse-like microwaves, the RF bias voltage, and the DC bias voltage are generated. The apparatus also has mixing means for applying the RF bias voltage and the DC bias voltage to the substrate without any interference, the arrangement provided being such that the RF bias voltage and the DC bias voltage are applied to the substrate in synchronism with the pulse-like microwaves. Therefore, both the RF bias voltage and the DC bias voltage are applied to the substrate only when the microwaves are being introduced into the plasma generating chamber and the plasma is being generated, thereby preventing damage to the substrate surface. In addition, it is possible to control the floating potential produced on the substrate by independently adjusting the respective magnitudes of the RF bias voltage and the DC bias voltage, so that it is possible to vary over a wide range the processing conditions for thin-film formation or etching. Thus, substrate processing under optimal conditions becomes possible.

Accordingly, in the formation of a thin film, it is possible simultaneously to control factors such as the composition of the film, the film quality, the stress applied to the film, to provide desired characteristics. In the etching process, on the other hand it is possible simultaneously to control anisotropy, damage to the film, and the processing speed, as desired.

Hence, it is possible to form a thin film having excellent step coverage by virtue of the sputtering effect while securing desired characteristics with respect to film quality and the stress applied to the film.

## Claims

1. Apparatus for processing a semiconductor device using microwave-generated plasma, said apparatus comprising a plasma-generating chamber (3) arranged to receive a gas and pulsed microwaves and having means (6) for providing a magnetic field in the chamber so as to generate a plasma due to resonance effects between the gas and the microwaves, said magnetic field serving to guide the plasma from the plasma-generating chamber (3) into a processing chamber (9) having means for supporting a substrate (11) with one of its surfaces arranged for thin-film formation or etching using said plasma, means being provided for evacuating the chambers, an RF bias generator (20), an RF bias modulation circuit (23), a DC bias generator (32) and a DC bias modulation circuit (33) being provided for respectively supplying and independently adjusting an RF bias voltage and a DC bias voltage, means (41) for mixing the RF and DC bias voltages and for supplying an interference-free combination of the latter to said substrate (11) and synchronising means (22) being provided for synchronising the bias voltages with the microwave pulses.

2. A method of processing a semiconductor device using microwave-generated plasma by means of the apparatus of claim 1, said method comprising the steps of supplying to a previously evacuated plasma-generating chamber (3) a gas and pulsed microwaves and providing a magnetic field in the chamber so as to generate a plasma due to resonance effects between the gas and the microwaves, said magnetic field serving to guide the plasma from the plasma-generating chamber (3) into a previously evacuated processing chamber (9), supporting a substrate (11) in the processing chamber (9) with one of its surfaces arranged for thin-film formation or etching using said plasma, supplying and independently adjusting an RF bias voltage and a DC bias voltage, mixing the two bias voltages and supplying an interference-free combination of the latter to said substrate (11) and synchronising the bias voltages with the microwave pulses.

3. Apparatus for processing a semiconductor device using microwave-generated plasma, said apparatus comprising a plasma-generating chamber (3) arranged to receive a gas and pulsed microwaves and having means (6) for providing a magnetic field in the chamber so as to generate a plasma due to resonance effects between the gas and the microwaves, said magnetic field serving to guide the plasma from the plasma-generating chamber into a processing chamber (9) having means for supporting a substrate (11) with one of its surfaces arranged for thin-film formation or etching using said plasma, means being provided for evacuating the chambers, an RF bias generator (20) being provided for supplying and independently adjusting an RF bias voltage, such that its magnitude varies with time in a predetermined manner during each microwave pulse, synchronising means (22) being provided for synchronising the RF bias voltage with the microwave pulses.

4. A method of processing a semiconductor device using microwave-generated plasma by means of the apparatus of claim 3, said method comprising the steps of supplying to a previously evacuated plasma-generating chamber (3) a gas and pulsed microwaves and providing a magnetic field in the chamber so as to generate a plasma due to resonance effects between the gas and the microwaves, said magnetic field serving to guide the plasma from the plasma-generating chamber (3) into a previously evacuated processing chamber (9), supporting a substrate (11) in the processing chamber (9) with one of its surfaces arranged for thin-film formation or etching using said plasma, supplying and independently adjusting an RF bias voltage, such that its magnitude varies with time in a predetermined manner during each microwave pulse, synchronising the RF bias voltage with the microwave pulses.

## Patentansprüche

1. Gerät zur Verarbeitung einer Halbleitervorrichtung unter Verwendung von durch Mikrowellen erzeugtem Plasma, wobei das Gerät eine Plasmaerzeugungskammer (3) aufweist, die ein Gas und Impulsmikrowellen aufnimmt und mit Elementen (6) zur Erzeugung eines Magnetfelds in der Kammer versehen ist, um das Plasma durch Resonanzeffekte zwischen dem Gas und den Mikrowellen zu erzeugen, wobei das Magnetfeld dazu dient, das Plasma aus der Plasmaerzeugungskammer (3) in eine Verarbeitungskammer (9) zu leiten, die mit Vorrichtungen zum Tragen eines Substrats (11) auf einer ihrer für die Dünnfilmbildung oder den Ätzvorgang unter Verwendung des Plasmas angeordneten Oberflächen versehen ist, und Elemente für das Leeren der Kammern, ein RF-Vorspannungsgenerator (20), ein RF-Vorspannungsmodulationskreis (23), ein DC -Vorspannungsgenerator (32) und ein DC-Vorspannungsmodulationskreis (33) für die Speisung bzw. unabhängige Justierung einer RF-Vorspannung und einer DC-Vorspannung, Elemente (41) zum Mischen der RF- und DC-Vorspannung und zur Zufuhr einer störfreien Kombination der Letzteren zu dem Substrat (11) sowie Synchronisierungselemente (22) zur Synchronisierung der Vorspannungen mit den Mikroweilenimpulsen vorgesehen sind.

2. Verfahren zur Verarbeitung einer Halbleitervorrichtung unter Verwendung von durch Mikrowellen erzeugtem Plasma, das mittels des in Anspruch 1 beschriebenen Gerats hergestellt wird, bestehend aus den Schritten der Einspeisung eines Gases und Impulsmikrowellen in eine zuvor geleerte Plasmaerzeugungskammer (3) und aus einem Magnetfeld in der Kammer, um ein Plasma durch die Resonanzeffekte zwischen dem Gas und den Mikrowellen zu erzeugen, wobei das Magnetfeld dazu dient, das Plasma aus der Plasmaerzeugungskammer (3) in eine zuvor geleerte Verarbeitungskammer (9) zu leiten, in der ein Substrat (11) in der Verarbeitungskammer (9) von einer der für die Dünnfilmbildung oder den Ätzvorgang unter Verwendung des Plasmas angeordneten Oberflächen getragen wird, der Einspeisung und unabhängigen Justierung einer RF-Vorspannung und einer DC-Vorspannung, des Mischens der beiden Vorspannungen, der Erzeugung einer störfreien Kombination der Letzteren mit dem Substrat (11) und der Synchronisierung der Vorspannungen mit den Mikrowellenimpulsen.

3. Gerät zur Verarbeitung einer Halbleitervorrichtung unter Verwendung von durch Mikrowellen erzeugtem Plasma, wobei das Gerät eine Plasmaerzeugungskammer (3) aufweist, die ein Gas und Impulsmikrowellen aufnimmt und mit Elementen (6) zur Erzeugung eines Magnetfelds in der Kammer versehen ist, um das Plasma durch Resonanzeffekte zwischen dem Gas und den Mikrowellen zu erzeugen, wobei das Magnetfeld dazu dient, das Plasma aus der Plasmaerzeugungskammer in eine Verarbeitungskammer (9) zu leiten, die mit Vorrichtungen zum Tragen eines Substrats (11) auf einer ihrer für die Dünnfilmbildung oder den Ätzvorgang unter Verwendung des Plasmas angeordneten Oberflächen versehen ist, und Elemente für das Leeren der Kammern, ein RF-Vorspannungsgenerator (20) für die Speisung und unabhängige Justierung einer RF-Vorspannung, so daß seine Größe auf vorbestimmte Art und Weise während eines jeden Mikrowellenimpulses zeitlich variiert, sowie Synchronisierungselemente (22) zum Synchronisieren der RF-Vorspannung mit den Mikrowellenimpulsen.

4. Verfahren zur Verarbeitung einer Halbleitervorrichtung unter Verwendung von durch Mikrowellen erzeugtem Plasma, das mittels des in Anspruch 3 beschriebenen Geräts hergestellt wird, bestehend aus den Schritten der Einspeisung eines Gases und Impulsmikrowellen in eine zuvor geleerte Plasmaerzeugungskammer (3) und aus einem Magnetfeld in der Kammer, um ein Plasma durch die Resonanzeffekte zwischen dem Gas und den Mikrowellen zu erzeugen, wobei das Magnetfeld dazu dient, das Plasma aus der Plasmaerzeugungskammer (3) in eine zuvor geleerte Verarbeitungskammer (9) zu leiten, in der ein Substrat (11) in der Verarbeitungskammer (9) von einer der für die Dünnfilmbildung oder den Ätzvorgang unter Verwendung des Plasmas angeordneten Oberflächen getragen wird, der Einspeisung und unabhängigen Justierung einer RF-Vorspannung, so daß ihre Größe auf vorbestimmte Art und Weise während eines jeden Mikrowellenimpulses zeitlich variiert, und der Synchronisierung der RF-Vorspannung mit den Mikrowellenimpulsen.

## Revendications

1. Dispositif pour traiter un composant à semiconducteur utilisant un plasma produit par des micro-ondes, ledit dispositif comprenant une chambre (3) de génération de plasma agencée pour recevoir un gaz et des micro-ondes pulsées et ayant un moyen (6) pour produire un champ magnétique dans la chambre de façon à générer un plasma dû à des effets de résonance entre le gaz et les micro-ondes, ledit champ magnétique servant à guider le plasma depuis la chambre (3) de génération de plasma jusque dans une chambre de traitement (9) ayant un moyen pour supporter un substrat (11) dont une surface est conçue pour la formation ou l'attaque d'une couche mince à l'aide dudit plasma, un moyen étant prévu pour faire le vide dans les chambres, un générateur de polarisation HF (20), un circuit (23) de modulation de polarisation HF, un générateur (32) de polarisation de courant continu et un circuit (33) de modulation de polarisation de courant continu étant respectivement prévus pour fournir et régler de manière indépendante une tension de polarisation HF et une tension continue de polarisation, un moyen (41) pour mélanger les tensions HF et continue de polarisation et pour fournir audit substrat (11) une combinaison de ces dernières exempte de parasites, un moyen de synchronisation (22) étant prévu pour synchroniser les tensions de polarisation avec les impulsions de micro-ondes.

2. Procédé de traitement d'un composant à semiconducteur utilisant un plasma produit par des micro-ondes à l'aide du dispositif selon la revendication 1, ledit procédé comprenant les étapes consistant à envoyer un gaz et des micro-ondes pulsées dans une chambre (3) de génération de plasma dans laquelle le vide a préalablement été fait et à produire un champ magnétique dans la chambre de façon à générer un plasma dû à des effets de résonance entre le gaz et les micro-ondes, ledit champ magnétique servant à guider le plasma depuis la chambre (3) de génération de plasma jusque dans une chambre de traitement (9) dans laquelle le vide a préalablement été fait, à supporter dans la chambre de traitement (9) un substrat (11) dont une des surfaces est conçue pour la formation ou l'attaque d'une couche mince à l'aide dudit plasma, à fournir et régler d'une manière indépendante une tension HF de polarisation et une tension continue de polarisation, à mélanger les deux tensions de polarisation et à fournir audit substrat (11) une combinaison de ces dernières exempte de parasites, et à synchroniser les tensions de polarisation avec les impulsions de micro-ondes.

3. Dispositif pour traiter un composant à semiconducteur utilisant un plasma généré par des micro-ondes, ledit dispositif comprenant une chambre (3) de génération de plasma agencée pour recevoir un gaz et des micro-ondes pulsées et ayant un moyen (6) pour produire un champ magnétique dans la chambre de façon à générer un plasma dû à des effets de résonance entre le gaz et les micro-ondes, ledit champ magnétique servant à guider les plasma depuis la chambre de génération de plasma jusque dans une chambre de traitement (9) ayant un moyen pour supporter un substrat (11) dont une des surfaces est conçue pour la formation ou l'attaque d'un film mince à l'aide dudit plasma, un moyen étant prévu pour faire le vide dans les chambres, un générateur (20) de polarisation HF étant prévu pour fournir et régler de manière indépendante une tension HF de polarisation, de façon que son amplitude varie d'une manière prédéterminée avec le temps pendant chaque impulsion de micro-ondes, un moyen de synchronisation (22) étant prévu pour synchroniser la tension HF de polarisation avec les impulsions de micro-ondes.

4. Procédé de traitement de composant à semiconducteur utilisant un plasma généré par des micro-ondes à l'aide du dispositif selon la revendication 3, ledit procédé comprenant les étapes consistant à fournir un gaz et des micro-ondes pulsées à une chambre (3) de génération de plasma dans lequel le vide a préalablement été fait, de façon à générer un plasma dû à des effets de résonance entre le gaz et les micro-ondes, ledit champ magnétique servant à guider le plasma depuis la chambre (3) de génération de plasma jusque dans une chambre de traitement (9) dans laquelle le vide a préalablement été fait, à supporter dans la chambre de traitement (9) un substrat (11) dont une des surfaces est conçue pour la formation ou l'attaque d'une couche mince à l'aide dudit plasma, à fournir et régler de manière indépendante une tension HF de polarisation, de façon que son amplitude varie avec le temps d'une manière prédéterminée pendant chaque impulsion de micro-ondes, à synchroniser la tension HF de polarisation avec les impulsions de micro-ondes.
